# EUROPEAN PATENT APPLICATION

(11) **EP 2 484 968 A1**
(43) Date of publication of application: **08.08.2012**
(21) Application number: 12154404.3
(22) Date of filing: 08.02.2012
(51) Int. Cl.: F21V 21/04, F21V 7/22, F21S 8/02, F21V 25/00

(54) **Recessed light fitting and method of manufacture**

(30) Priority: 08.02.2011 GB 201102129
(71) Applicant: Jones, Peter Charles, Shipston-on-Stour CV36 5AA (GB)
(72) Inventor: Jones, Peter Charles, Shipston-on-Stour CV36 5AA (GB)
(74) Representative: Gee, Steven William

(57) **Abstract**

This invention relates to a recessed light fitting and to its method of manufacture. The invention provides recessed light fitting (10) having a housing (14, 16) containing a reflector (20), **characterised in that** the reflector carries a first (30) and a second (32) fire-resistant coating, and the housing (14) carries a third (34) and a fourth (36) fire-resistant coating. The invention also provides methods in which the second fire-resistance coating is applied over a pre-applied first fire-resistant coating, and in which the third fire-resistance coating is applied over a pre-applied fourth fire-resistant coating.

## Description

### FIELD OF THE INVENTION

This invention relates to a recessed light fitting and to its method of manufacture, and relates in particular to a recessed light fitting for a ship.

### BACKGROUND OF THE INVENTION

Recessed light fittings are in widespread use in ships. They have a housing which is recessed into a part of the structure of the ship, so that the lens or cover of the light fitting is substantially flush with the surface of the structure. The housing will typically be recessed into an aperture formed in the (metal) bulkhead providing the ceiling panel. Recessed light fittings are therefore distinguished from surface mounted light fittings which are mounted upon the surface of the ceiling panel or the like and protrude into the illuminated area.

Fire is a recognised concern on ships, and steps are taken to reduce the likelihood that a fire can spread throughout a ship. One possible route for fire to spread is within the structure of the ship, i.e. behind the bulkheads where a continuous path for the fire may be present. Once present within the structure, a fire can spread without being readily visible, and access to combat the fire is severely limited.

Providing apertures in the bulkhead into which the recessed light fittings can be inserted is disadvantageous as far as fire risk is concerned, as the apertures provide possible routes for fire, heat and smoke to pass into the structure of the ship from an illuminated area, or to pass from the structure of the ship into an illuminated area.

To avoid the apertures being a passage for fire, heat and smoke it is usual to provide a metal casing attached to the back surface of the bulkhead surrounding the aperture. The aperture is therefore isolated from the remainder of the structure of the ship behind the bulkhead by the metal casing.

One particular recessed light fitting for a ship is manufactured by Aqua Signal AG of Bremen, Germany, and is identifiable as type "GCN(M) 14 N 110/113 F W N E". That light fitting is typical of many recessed light fittings used on ships, and comprises a housing and a cover, the cover being removable to allow the insertion of a lamp unit into the housing. Part of the housing is formed as a reflector which can partially surround a fitted lamp unit and act to reflect some of the emitted light through the cover.

The lamp unit is typically fluorescent, and so the housing also carries a driver in the form of a ballast and other componentry to ignite and drive the lamp unit. To keep the driver protected from the heat generated by the lamp unit as much as possible, the driver is typically carried in an extension of the housing, and is typically separated from the reflector and the fitted lamp unit by a partition within the housing.

### SUMMARY OF THE INVENTION

The present invention seeks to enhance the fire rating of the recessed light fitting, i.e. to increase the resistance to the passage of fire and heat through the aperture in the bulkhead. The invention seeks to provide a light fitting which is sufficiently resistant to the passage of fire and heat as to avoid the requirement for the metal casing. The avoidance of the metal casing for each of the recessed light fittings of a ship represents a considerable saving in terms of manufacturing cost, and also in terms of running costs because of the reduction in weight (the combined weight of the metal casings on a large ship can be as much as 15 tonnes).

Notwithstanding its primary utility with ships, the invention has utility in other applications utilising recessed light fittings, for example in buildings.

According to the present invention, there is provided a recessed light fitting for fitment into a preformed aperture, the light fitting having a housing containing a reflector and a driver for a lamp unit, **characterised in that** the reflector carries a first and a second fire-resistant coating, and the housing carries a third and a fourth fire-resistant coating.

Preferably, the housing carries the third and fourth fire-resistant coatings on its inside surface, i.e. the surface facing the reflector, so that the coatings on the reflector and the coatings on the housing face each other.

Preferably the first fire-resistant coating is applied to the reflector and the second fire-resistant coating is applied to the first fire-resistant coating. Preferably also the fourth fire-resistant coating is applied to the housing and the third fire resistant coating is applied to the fourth fire-resistant coating.

Desirably, the four fire-resistant coatings are provided by two separate materials. Desirably also the first and fourth fire-resistant coatings are of a first material and the second and third fire-resistant coatings are of a second material. This enables the selection of a first material which is suited to adhere to the metal surfaces of the reflector and the housing, and the selection of second material which is suited to adhere to the first material.

If desired, it is arranged that the coatings are sufficiently thin that there is a gap between the second and third fire-resistant coatings. Preferably that gap can be filled by a third fire-resistant material so as to reduce or eliminate any significant air gaps within the housing.

One or more of the first, second and third materials may be intumescent.

If desired, the outside surface of the housing can carry a fifth fire-resistant coating and a sixth fire-resistant coating. In such embodiments, the fifth fire-resistant coating is preferably of the first material and the sixth fire-resistant coating is of the second material.

Desirably, the first material is a lithium-containing silicate material, such as those described in UK patent application 2 444 926. Such a material is very fire-resistant and can readily be applied as a coating to metal surfaces.

Preferably, the second material is Firefree88"^{®} which is an intumescent fireproofing material available from Firefree Coatings, Inc., 580 Irwin Street, No. 1, San Rafael, California 94901, U.S.A.

Preferably the third material is Kaowool®, which is another known fireproofing material containing aluminosilicate glass wool suitable for thermal insulation and heat shield applications, and is available from Morgan Thermal Ceramics Limited, Tebay Road, Bromborough, Wirral, CH62 3PH, England. Alternatively, the third material is Super Therm®, which is a known thermal barrier ceramic coating comprising aliphatic urethanes, elastomeric acrylics and resin additives, and is supplied by Superior Products Europe n.v. /s.a. of Kampweg 123 - 2990 Wuustwezel (Antwerp) Belgium.

Whilst each of these materials is separately known for its fire- and/or heat-resistant properties, they have previously not been used together. In particular, the present inventor is the first to appreciate that a lithium-containing silicate material can be used as a base coat on a metal surface, and provide a good foundation for the Firefree88 material which is very suitable as a coating material for surfaces such as timber but does not adhere well to metal surfaces such as those of the reflector and the housing.

When used together, these materials, in the coating patterns described, allow a recessed light fitting to pass the required fire tests for a ships light fitting, despite the absence of the metal casing.

### BRIEF DESCRIPTION OF THE PREFERRED EMBODIMENTS

The invention will now be described in more detail, by way of example, with reference to the accompanying drawings, in which:
Fig.1 is a perspective view, from below, of a recessed light fitting; and
Fig.2 is a side sectional view of the fitting.

### DETAILED DESCRIPTION

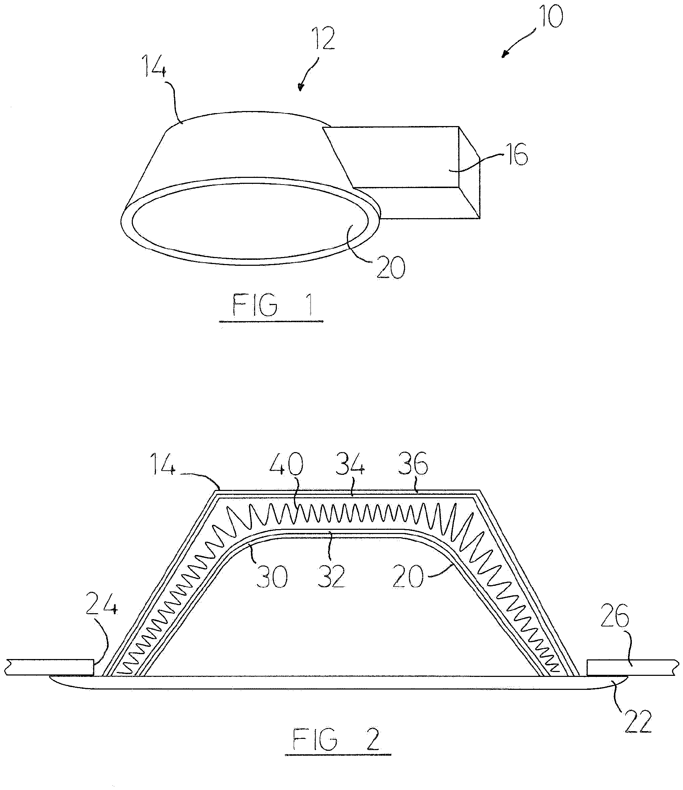

Fig.1 shows a perspective view of a recessed light fitting 10 according to the present invention. The light fitting 10 includes a housing 12 which in common with many prior art recessed light fittings is formed of two parts, a first housing part 14 and an extension 16. Within the housing part 14 is mounted a reflector 20, the interior surface of which is covered with a highly reflective material, in known fashion. A lamp unit (not shown) is located within the reflector. The lamp unit can be of any suitable form such as fluorescent or LED for example.

The housing part 14 has a flange 22. A lens or transparent cover (not shown) is carried by the housing and lies substantially flush with the flange 22. The lens or transparent cover can be removed to provide an opening in the housing through which access can be gained to remove and replace the lamp unit.

The recessed light fitting 10 is designed for fitment into an aperture 24 formed in a suitable ceiling panel such as the bulkhead 26 of a ship. The aperture 24 is formed to accommodate all of the housing except the flange 22, and when fitted as shown in Fig.2 the flange 22 lies against the surface of the bulkhead 26 adjacent to the aperture 24, and is secured thereto by screws or other known fasteners (not shown) in known fashion.

According to the present invention the rear or non-reflective surface of the reflector 20 carries a first fire-resistant coating 30, and the first fire-resistant coating 30 carries a second fire-resistant coating 32. Also, the inside surface of the housing part 14 carries a fourth fire-resistant coating 36 and the fourth fire-resistant coating carries a third fire-resistant coating 34. Accordingly, there are four fire-resistant coatings 30, 32, 34 and 36 between the reflector 20 and the housing 14.

Fig.2 is a section across the housing 14, and does not therefore show the extension 16, nor the lamp unit. It will be understood that the housing 14 includes an opening communicating with the extension 16, and that the reflector 20 includes a recess or opening for the lamp unit. The extension 16 is preferably separated from the housing part 14 by a metallic partition which is also coated in a similar fashion to the housing part 14, and the recess or opening for the lamp unit is preferably closed as far as is practicable and coated in a similar fashion to the remainder of the reflector 20. In this way, it can be arranged that the coatings 30, 32, 34 and 36 are substantially continuous and the only discontinuity is due to the wires or connectors necessary to communicate the electrical energy from the driver within the extension 16 to the lamp unit. The likelihood of the discontinuities in the coatings providing a pathway for the transmission of heat or fire can thereby be reduced or eliminated.

The embodiment shown also includes the optional third material, in the form of a heat-resistant packing material 40, suitably Kaowool^{®} or the like.

In another embodiment the outside surface of the housing 14 (i.e. that surface facing away from the reflector 20) carries at least one coating, and preferably two coatings, ideally a fifth coating of similar material to the coating 36 and a sixth coating of similar material to the coating 34.

In yet another embodiment, the third material (such as Kaowool^{®} or Super Therm®) is provided as one or more layers upon each of the coatings 32 and 34, for example 3 layers of 2mm thick Kaowool^{®} material, or a coating of Super Therm® material, adhered upon each of the coatings 32 and 34.

## Claims

1. A recessed light fitting (10) having a housing (14, 16) containing a reflector (20), **characterised in that** the reflector carries a first fire-resistant coating (30) and a second (32) fire-resistant coating, and the housing (14) carries a third fire-resistant coating (34) and a fourth (36) fire-resistant coating.

2. A recessed light fitting according to claim 1 in which the housing (14) carries the third (34) and fourth (36) fire-resistant coatings on its inside surface, the coatings (30, 32) on the reflector and the coatings (34, 36) on the housing facing each other.

3. A recessed light fitting according to claim 1 or claim 2 in which the first fire-resistant coating (30) covers substantially all of the non-reflecting surface of the reflector (20), and the second fire-resistant coating (32) completely covers the first fire-resistant coating.

4. A recessed light fitting according to any one of claims 1-3 in which the fourth fire-resistant coating (36) covers substantially all of the inside surface of the housing (14), and the third fire-resistant coating (34) completely covers the fourth fire-resistant coating.

5. A recessed light fitting according to any one of claims 1-4 in which the four fire-resistant coatings (30, 32, 34, 36) comprise two different materials.

6. A recessed light fitting according to claim 5 in which the first (30) and fourth (36) fire-resistant coatings are of a first material and the second (32) and third (34) fire-resistant coatings are of a second material.

7. A recessed light fitting according to any one of claims 1-6 in which the second (32) and third (34) fire-resistant coatings are spaced apart.

8. A recessed light fitting according to claim 7 in which the space between the second (32) and third (34) fire resistant coatings is at least partially filled by another fire-resistant material (40).

9. A recessed light fitting according to claim 8 in which the another fire-resistant material (40) is intumescent.

10. A recessed light fitting according to any one of claims 1-9 in which at least one of the four fire-resistant coatings (30, 32, 34, 36) is intumescent.

11. A recessed light fitting according to any one of claims 1-10 in which the outside surface of the housing (14) carries a fifth fire-resistant coating and a sixth fire-resistant coating, in which the fifth fire-resistant coating is of the same material as the first (30) fire-resistant coating, and in which the sixth fire-resistant coating is of the same material as the second (32) fire-resistant coating.

12. A recessed light fitting according to any one of claims 1-11 in which the first (30) and fourth (36) fire-resistant coatings comprise a lithium-containing silicate material.

13. A recessed light fitting according to any one of claims 1-12 in which the second (32) and third (34) fire-resistant coatings comprise an intumescent fireproofing material.

14. A method of making a recessed light fitting according to any one of claims 1-13 in which the first fire-resistant coating (30) is applied to the reflector (20) and the second fire-resistant coating (32) is applied to the first fire-resistant coating.

15. A method according to claim 14 in which the fourth fire-resistant coating (36) is applied to the housing (14) and the third fire resistant coating (34) is applied to the fourth fire-resistant coating.
